# EUROPÄISCHE PATENTSCHRIFT

(11) **EP 1 484 950 B1**
(45) Veröffentlichungstag und Bekanntmachung des Hinweises auf die Patenterteilung: **11.10.2006**
(21) Anmeldenummer: 04008025.1
(22) Anmeldetag: 01.04.2004
(51) Int. Cl.: H05K 3/40, H05K 3/34

(54) **Elektrisches Kontaktierungsverfahren**
Method for electrical connection
Méthode de mise en contact èlectrique

(30) Priorität: 05.06.2003 DE 10325550
(43) Veröffentlichungstag der Anmeldung: 08.12.2004
(73) Patentinhaber: Novar GmbH, 41469 Neuss (DE)
(72) Erfinder: Gernhardt, Angelika, 41464 Neuss (DE); Goulet, Thomas, 40699 Erkrath (DE); Menzel, Carsten, 47137 Duisburg (DE); Ollik, Waldemar, 47495 Rheinberg (DE)
(74) Vertreter: Prietsch, Reiner

(56) Entgegenhaltungen:
- EP-A- 0 878 987
- US-A- 4 790 894
- US-A- 5 570 505
- US-B1- 6 518 088

## Beschreibung

Die Erfindung betrifft ein Verfahren zur elektrischen Kontaktierung von an mindestens einem Rand einer Schaltungsplatine endenden Leiterbahnen mit einem angrenzenden Bauteil.

Aus der US 4 790 894 ist eine aus einem Nutzen herausgetrennte Schaltungsplatine bekannt, die Randkontakte aus metallisierten Halbbohrungen hat. Diese Platine wird auf einer sog. Mutterplatine angebracht, in dem sie mit der Mutterplatine im Bereich der metallisierten Halbbohrungen verlötet wird.

Als sog. Molded Injection Devices, also in MID-Technologie hergestellte, elektrische Bauteile können nach verschiedenen Verfahren, z.B. dem Maskenverfahren, im Zweikomponenten-Spritzguss mit nachfolgender galvanischer Metallisierung, durch Laserdirektstrukturierung, durch Hinterspritzen einer Folie oder durch Heißprägen mit den gewünschten Leiterbahnen versehen werden. So hergestellte MID-Bauteile sind - im Gegensatz zu konventionellen Schaltungsplatinen aus GFK oder dergleichen - dreidimensionale Formteile mit integriertem Leiterbahnen-Layout und ggf. weiteren, elektronischen oder elektromechanischen Komponenten.

Der Einsatz derartiger MID-Bauteile, auch wenn sie lediglich mit Leiterbahnen versehen sind und als Ersatz für eine konventionelle Verdrahtung innerhalb eines elektrischen oder elektronischen Geräts dienen, ist nicht nur platzsparend und erlaubt damit eine Verkleinerung des betreffenden Geräts sondern senkt auch die Fertigungskosten durch Verminderung der Zahl der Montage- und der Kontaktierungsschritte.

Allerdings eignen sich MID-Bauteile nicht als Ersatz für klassische Leiterplatten oder Schaltungsplatinen, auf denen zahlreiche elektronische Komponenten mit hoher Packungsdichte und sehr geringem Abstand der Leiterbahnen in SMD-Technik angeordnet sind. In diesen Fällen stellte sich bisher das Problem, eine oder mehrere Schaltungsplatinen mit einem MID-Bauteil zu kontaktieren. Die bisherigen Verfahren, nämlich das Einlöten von Drahtbrücken oder mechanische Kontaktierungen über Steckkontaktleisten, Federleisten, Leitgummistreifen, usw. sind materialaufwendig, zum Teil platzraubend, teuer und kosten wertvolle Fertigungszeit.

Der Erfindung liegt die Aufgabe zugrunde, ein besonders rationelles, gleichwohl zuverlässiges Kontaktierungsverfahren der einleitend angegebenen Gattung zu schaffen.

Diese Aufgabe ist durch ein Verfahren gemäß Anbspruch 1 gelöst.

Eine Verbesserung der durch die Lötung gleichzeitig geschaffenen, mechanischen und elektronischen Verbindung zwischen der Schaltungsplatine und dem MID-Bauteil bei sehr geringem zusätzlichem Fertigungsaufwand ist dadurch erreicht, dass der Nutzen rückseitig mindestens im Bereich der Trennlinie deckungsgleich zu den vorderseitigen Leiterbahnen mit elektrischen Kontaktierungsflächen (pads) versehen ist. Letztere können sich bei doppelseitig bestückten Schaltungsplatinen in rückseitigen, signalführenden Leiterbahnen fortsetzen.

Da die vorderseitigen Leiterbahnen mit den rückseitigen Kontaktierungsflächen, auch soweit diese sich in rückseitigen Leiterbahnen fortsetzen, über metallisierte und durchkontaktierte Bohrungen verbunden sind, stellt diese Durchkontaktierung eine sichere elektrische Verbindung mit der betreffenden Leiterbahn des MID-Bauteiles auch dann her, wenn die Metallisierung der entsprechenden, randseitigen halbzylindrischen Fläche wegen unzureichenden Kantenumgriffs oder aus anderen Gründen keine oder eine nur unzureichende elektrische Verbindung zwischen der vorderseitigen Leiterbahn bzw. deren Verbreiterung zu einer Kontaktierungsfläche und der rückseitigen Leiterbahn oder Kontaktierungsfläche der Schaltungsplatine hat.

Der mechanischen Festigkeit kommt es vor allem zugute, dass die Schaltungsplatine und das MID-Bauteil so zueinander positioniert werden, dass die miteinander zu kontaktierenden Leiterbahnen der Schaltungsplatine einerseits und des MID-Bauteils andererseits etwa um die Dicke der Schaltungsplatine gegeneinander höhenmäßig versetzt sind und sich überlappen. Dadurch wird eine flächenmäßig größere Lötverbindung zwischen der Platine und dem MID-Bauteil geschaffen.

Zur Herstellung von mehr als einer Schaltungsplatine je Nutzen werden alternativ zu dem Schritt a) des Anspruches 1
a') auf einem mindestens zwei Schaltungsplatinen liefernden, mindestens einseitig kupferkaschierten Nutzen die Leiterbahnen der Schaltungsplatinen in einem Layout erzeugt, bei dem die später dem MID-Bauteil zugewandten Ränder längs einer gemeinsamen Trennlinie aneinandergrenzen und die betreffenden Leiterbahnen diese Trennlinie überbrücken (Anspruch 2).

Die weiteren Schritte b) bis e) laufen ab wie zuvor.

Praktisch ohne Zusatzaufwand lässt sich die Kontaktierungssicherheit dadurch steigern, dass die Leiterbahnen der Schaltungsplatine zumindest an deren Rand zu Kontaktierungsflächen, ebenfalls pads genannt, verbreitert werden (Anspruch 3). Dort, wo keine Leiterbahnen aus schaltungstechnischen Gründen benötigt werden, genügt es, randseitig nur pads auszubilden.

Die Leiterbahnen der Schaltungsplatine und diejenigen des MID-Bauteils können insbesondere nach dem Reflow-Verfahren miteinander verlötet werden (Anspruch 4). Andere Kontaktierungsverfahren wie Laser-, Heißdampfphasen- oder Roboterlöten oder Leitkleben können jedoch ebenfalls angewendet werden. Das zuvor erforderliche Aufbringen von Lötpaste kann z.B. nach dem Siebdruckverfahren oder punktweise mittels Dispenser-Robotern erfolgen.

Der Nutzen oder die Schaltungsplatine kann noch vor der Kontaktierung mit den Leiterbahnen des MID-Bauteiles zumindest teilweise bestückt werden (Anspruch 5), so dass beispielsweise in einem nachfolgenden Reflow-Prozess sowohl die bestückten Komponenten mit den Leiterbahnen der Schaltungsplatine als auch letztere mit dem MID-Bauteil in einem Schritt verlötet werden.

Besonders geeignet ist das vorgeschlagene Kontaktierungsverfahren in Verbindung mit MID-Bauteilen, auf welche die Leiterbahnen z.B. im Heißprägeverfahren (Anspruch 6) oder durch Laserdirektstrukturierung (Anspruch 7) aufgebracht sind.

Zur Durchführung des Verfahrens gemäß einem der Ansprüche ist es besonders vorteilhaft, wenn zunächst
- auf einem mindestens eine Schaltungsplatine liefernden, mindestens einseitig kupferkaschierten Nutzen die Leiterbahnen der Schaltungsplatine in einem Layout erzeugt werden, bei dem die Leiterbahnen über eine Trennlinie hinaus verlängert sind, die den später dem MID-Bauteil zugewandten Rand der Schaltungsplatine definiert.
- Der Nutzen wird dann längs der Trennlinie mindestens im Bereich der Leiterbahnen mit Durchgangsbohrungen versehen, und
- die Durchgangsbohrungen werden galvanisch durchkontaktiert.
- Anschließend wird die Schaltungsplatine aus dem Nutzen herausgetrennt, und
- die Schaltungsplatine relativ zu dem MID-Bauteil positioniert und die aneinandergrenzenden Leiterbahnen der Schaltungsplatine und des MID-Bauteils werden miteinander verlötet.

Der Kern des zuvor beschriebenen Vorgehens besteht also darin, die zu kontaktierenden Leiterbahnen auf dem Nutzen, also der Tafel, aus der später die Schaltungsplatine(n) herausgetrennt wird (werden), über den späteren Rand der Schaltungsplatine(n) hinaus in dem gleichen Raster, in welchem die Leiterbahnen des MID-Bauteiles an dessen Rand enden, zu verlängern, diese Leiterbahnen genau in Höhe des späteren Randes mit durchkontaktierten Durchgangsbohrungen zu versehen und dann erst die Schaltungsplatine aus dem Nutzen z.B. herauszubrechen oder herauszustanzen, so dass jede Leiterbahn an einer metallisierten halbzylindrischen Fläche endet. Im Fall einer einzelnen Platine genügt es, wenn der Nutzen um einen entsprechenden Randstreifen größer als die Schaltungsplatine ist. In Höhe des späteren, tatsächlichen Randes der Platine wird diese mit den durchkontaktierten Durchgangsbohrungen versehen. Anschließend wird der überflüssige Randstreifen weggebrochen. Wenn, wie in der Regel, mehrere Schaltungsplatinen gleichzeitig erzeugt werden sollen, ist es wesentlich günstiger, gemäß der vorstehend erläuterten Alternative zur Herstellung mehrerer Schaltungsplatinen zu verfahren. Dann liegen sich auf den Nutzen jeweils mindestens zwei Schaltungsplatinen Kopf an Kopf gegenüber, z.B. in der Weise, dass das Layout der einen Schaltungsplatine um 180° um die Hochachse gedreht im Verhältnis zu der anderen Schaltungsplatine auf dem Nutzen erzeugt wird. Zweckmäßig wird über im Wesentlichen die gesamte Länge des betreffenden Randes ein Leiterbahnraster erzeugt, unabhängig davon, wie viele Leiterbahnen elektrische Signale leiten. Das Gleiche gilt für den korrespondierenden Rand des MID-Bauteiles. Auf diese Weise wird die maximale Festigkeit der mechanischen Verbindung zwischen der Schaltungsplatine und dem MID-Bauteil erzielt.

Eine so vorbereitete Schaltungsplatine lässt sich problemlos mit den Leiterbahnen des angrenzenden MID-Bauteils verlöten. Diese Art der Kontaktierung erweist sich als elektrisch sicher und zuverlässig sowie als mechanisch äußerst stabil. Das vorgeschlagene Verfahren benötigt keine zusätzlichen Verbindungselemente und ist schon aus diesem Grund kostensparend. Gleichzeitig spart es auch Platz auf der Schaltungsplatine.

Das Verfahren nach der Erfindung wird nachfolgend beispielhaft anhand der schematisch vereinfachten Zeichnung erläutert. Es zeigt:
- Fig. 1: eine perspektivische Aufsicht auf eine Schaltungsplatine,
- Fig. 2: die gleiche Schaltungsplatine in der Rückansicht,
- Fig. 3: einen vier derartige Schaltungsplatinen umfassenden Nutzen,
- Fig. 4: eine fertige Schaltungsplatine, mechanisch und elektrisch verbunden mit einem in MID-Technik ausgeführten Bauteil und
- Fig. 5: eine der Kontaktierungsstellen in starker Vergrößerung entsprechend einem Schnitt längs der Linie A-A in Fig. 4.

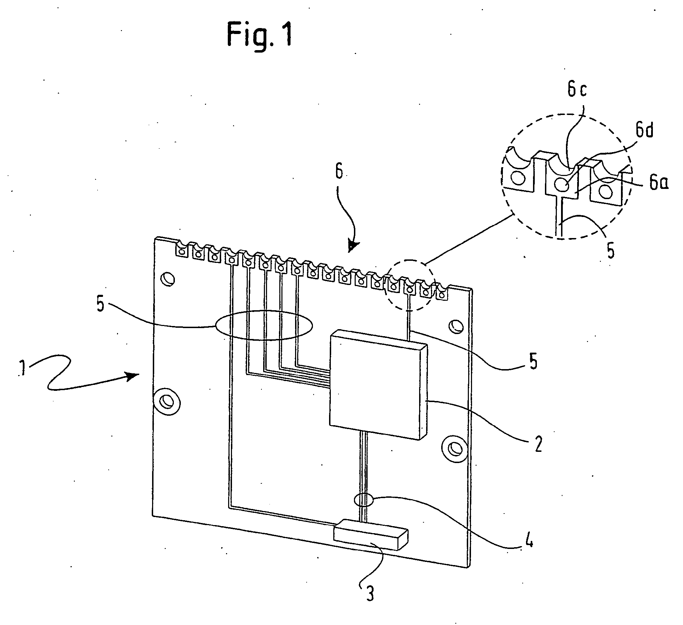

**Fig. 1** zeigt perspektivisch und vereinfacht eine z.B. aus glasfaserverstärktem Expoxidharz bestehende Schaltungsplatine 1, die mit hier nur symbolisch dargestellten Komponenten 2 und 3 bestückt ist, welche über Leiterbahnen 4 untereinander verbunden sind. Über weitere Leiterbahnen 5 sind Stromversorgungs- und Signalanschlüsse der Komponenten 2 und 3 an Randkontakte 6 am oberen Rand der Schaltungsplatine geführt. Jede Leiterbahn geht dort, vergl. den vergrößerten Ausschnitt, breiterte Kontaktierungsfläche 6a über. Die Kontaktierungsflächen 6a sind in einem vorgegebenen Raster angeordnet, und zwar nahezu längs des gesamten oberen Randes der Schaltungsplatine 1, auch soweit sie nicht als herausgeführte elektrische Anschlüsse benötigt werden. Die Schaltungsplatine 1 kann auch rückseitig mit Leiterbahnen versehen und mit elektrischen Komponenten bestückt sein.

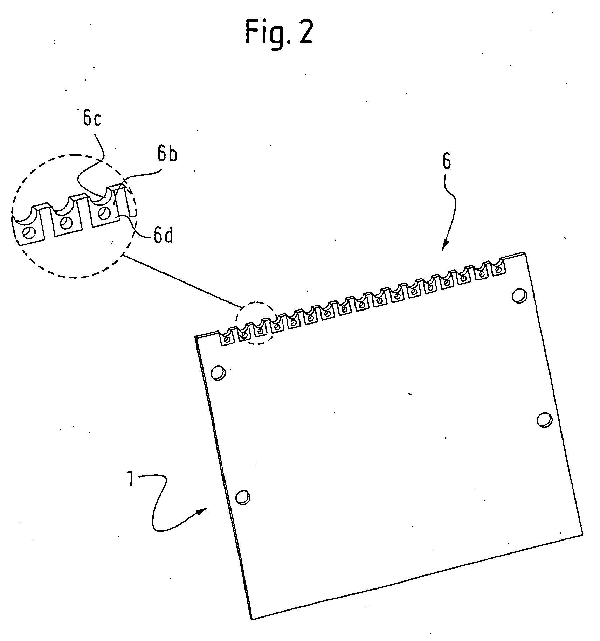

Auch wenn die Schaltungsplatine - wie in diesen Ausführungsbeispiel - nur vorderseitig mit Leiterbahnen und Komponenten versehen ist, liegen den Kontaktierungsflächen 6a, wie **Fig. 2** zeigt, auf der Rückseite der Schaltungsplatine identische Kontaktierungsflächen 6b gegenüber. Die Kontaktierungsflächen 6a und 6b sind sowohl über halbzylindrische Flächen 6c, die im Oberrand der Schaltungsplatine 1 ausgebildet sind, als auch zusätzlich über durchkontaktierte Bohrungen 6d miteinander verbunden.

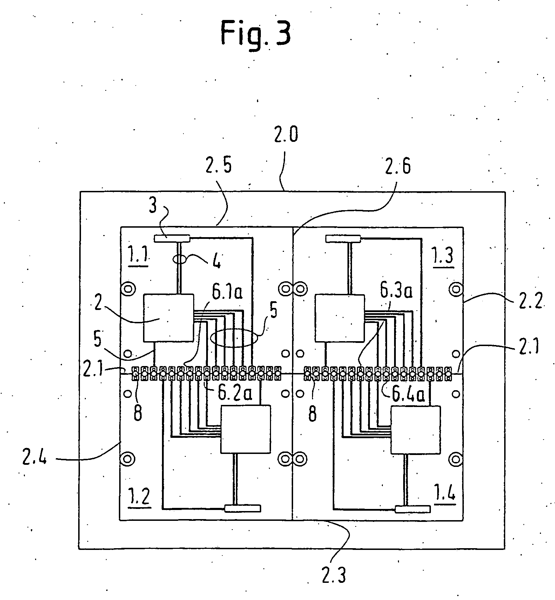

Die Randkontakte 6 der Schaltungsplatine 1 werden nach dem anhand der **Fig. 3** erläuterten Verfahren erzeugt. Auf einem beidseitig kupferkaschierten Nutzen 20 wird nach einem der bekannten Verfahren vorder- und rückseitig ein Layout erzeugt, das vier identischen Platinen 1.1 bis 1.4 entspricht, die nur zur Verdeutlichung hier als vorderseitig schon mit den Komponenten 2 und 3 bestückt dargestellt sind. Das Layout ist so ausgelegt, dass sich jeweils zwei Platinen, nämlich 1.1 und 1.2 sowie 1.3 und 1.4, mit ihren die Randkontakte tragenden Rändern aneinandergrenzend gegenüber liegen. In diesem Beispiel sind also die Layouts der Platinen 1.2 und 1.4 um 180° um die Hochachse gedreht gegenüber dem Layout der Platinen 1.1 und 1.3. Vor oder nach dem Erzeugen der Leiterbahnen 4 und 5 einschließlich der Kontaktierungsflächen 6a sowie der hier nicht sichtbaren, rückseitigen Leiterbahnen und Kontaktierungsflächen wird der Nutzen längs der Trennlinie 21, über die hinweg sich die Kontaktierungsflächen 6.1a, 6.2a und 6.3a, 6.4a erstrecken, mit Durchgangsbohrungen 8 und den Bohrungen 6d in Höhe dieser Kontaktierungsflächen und im gleichen Raster wie letztere versehen. In diesem Schritt werden auch sämtliche sonst benötigten Bohrungen, insbesondere die zur Bestückung und Kontaktierung der Komponenten 2 und 3 notwendigen Bohrungen, hergestellt. Anschließend werden sämtliche Bohrungen, d.h. auch die Durchgangsbohrungen 8 und die Bohrungen 6d, nach einem der gebräuchlichen Verfahren galvanisch durchkontaktiert. Im letzten Schritt werden die Platinen 1.1 bis 1.4 aus dem Nutzen 20 längs der Trennlinien 21 bis 26 ausgestanzt. Im Bereich des jeweiligen zu kontaktierenden Randes der Schaltungsplatinen 1.1 bis 1.4 sind dann die Kontaktierungsflächen 6a, 6b gemäß Fig. 1 über die halbzylindrischen metallisierten Flächen 6c und zusätzlich über die durchmetallisierten Bohrungen 6d elektrisch leitend verbunden. Selbst wenn im Zuge des Ausstanzens die dünne, nur wenige µ starke Metallisierung der halbzylindrischen Flächen 6c beschädigt werden sollte, stellt die Durchkontaktierung im Bereich der Bohrungen 6d die elektrische Verbindung der jeweiligen Kontaktierungsfläche 6a mit der rückseitigen Gegenfläche 6b sicher.

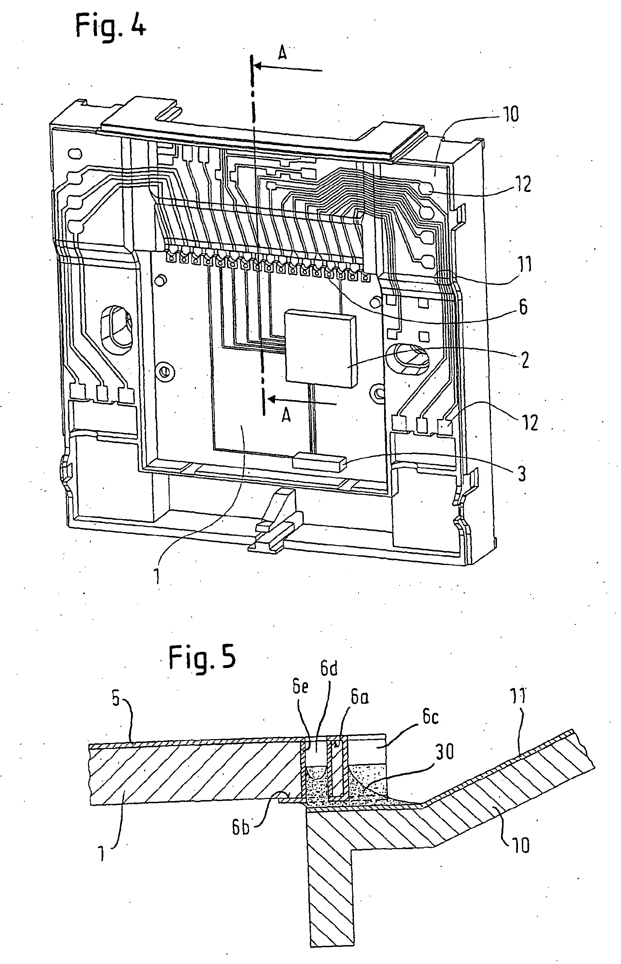

Die Schaltungsplatine 1 ist zur elektrischen und mechanischen Verbindung mit einem in MID-Technologie hergestellten, elektrischen Bauteil bestimmt. **Fig. 4** zeigt beispielhaft ein solches MID-Bauteil in Form eines Gehäuseunterteils 10, dessen dreidimensionale Fläche zahlreiche z.B. nach dem Heissprägeverfahren oder durch Laserdirektstrukturierung erzeugte Leiterbahnen 11 trägt, die an Kontaktierungsflächen 12 enden, auf welche weitere elektrische Komponenten (nicht dargesstellt) aufgelötet werden. Die Leiterbahnen 11 sind mit den Randkontakten 6 der Schaltungsplatine 1 verlötet. Die Verlötung nach irgendeinem der bekannten Verfahren dient sowohl der elektrischen Kontaktierung als auch der mechanischen Fixierung der Schaltungsplatine 1 in dem Gehäuseunterteil 10.

**Fig. 5** zeigt die Lötverbindung in einem vergrößerten Schnitt längs der Linie A-A in Figur 4. Die Platine 1 liegt mit ihrem Rand überlappend auf dem Rand des MID-Bauteiles 10 auf. Die oberseitige Kontaktierungsfläche 6a ist mit der unterseitigen Kontaktierungsfläche 6b einerseits über die metallisierte, halbzylindrische Fläche 6c und andererseits über die Metallisierung 6e der Bohrung 6d verbunden. Die Leiterbahn 11 des MID-Bauteils 10 ist über das Lot 30 sowohl mit der halbzylindrischen Fläche 6c als auch mit der unteren Kontaktierungsfläche 6b verbunden und füllt infolge Kapillarwirkung mindestens den Spalt zwischen dieser unterseitigen Kontaktierungsfläche 6b und dem Ende der Leiterbahn 11.Infolge Kapillarwirkung steigt das Lot 30 auch in die Bohrung 6d.

## Patentansprüche

1. Verfahren zur elektrischen Kontaktierung von an mindestens einem Rand einer Schaltungsplatine (1) endenden Leiterbahnen (5) mit auf einem angrenzenden Bauteil angebrachten Leiterbahnen mit den Schritten,
a) auf einem mindestens eine Schaltungsplatine liefernden, mindestens einseitig kupferkaschierten Nutzen (20) werden die Leiterbahnen der Schaltungsplatine in einem Layout erzeugt, bei dem die Leiterbahnen über eine Trennlinie (21) hinaus verlängert sind, die den später dem angrenzenden Bauteil zugewandten-Rand der Schaltungsplatine definiert,
b) der Nutzen wird längs der Trennlinie mindestens im Bereich der Leiterbahnen mit Durchgangsbohrungen (8) versehen,
c) die Durchgangsbohrungen werden galvanisch durchkontaktiert,
d) die Schaltungsplatinen werden aus dem Nutzen herausgetrennt, und
e) jede der zu kontaktierenden Schaltungsplatinen wird relativ zu dem jeweiligen Bauteil (10) positioniert und die aneinandergrenzenden Leiterbahnen der Schaltungsplatine und des Bauteils werden miteinander verlötet,
**dadurch gekennzeichnet, dass**
- das angrenzende Bauteil aus einem Thermoplast ist und dessen Leiterbahnen in MID-Technologie aufgebrachte Leiterbahnen sind,
- der Nutzen rückseitig mindestens im Bereich der Trennlinie deckungsgleich zu den vorderseitigen Leiterbahnen mit elektrischen Kontaktierungsflächen (6b) versehen wird, und metallisierte und durchkontaktierte Bohrungen (6d) vorgesehen werden, die
- die vorderseitigen Leiterbahnen (5) mit den rückseitigen Kontaktierunsflächen (6b) verbinden, und
- dass die Schaltungsplatine und das MID-Bauteil so zueinander positioniert werden, dass die miteinander zu kontaktierenden Leiterbahnen der Schaltungsplatine einerseits und des MID-Bauteils andererseits um die Dicke der Schaltungsplatine gegeneinander höhenmäßig versetzt sind und sich überlappen.

2. Verfahren nach Anspruch 1 zur gleichzeitigen Herstellung von mehr als einer Schaltungsplatine, **dadurch gekennzeichnet, dass** anstelle des Schrittes a) folgender Schritt tritt:
a') Auf einem mindestens zwei Schaltungsplatinen liefernden, mindestens einseitig kupferkaschierten Nutzen (20) werden die Leiterbahnen (5) der Schaltungsplatinen (1.1,1.2,1.3,1.4) in einem Layout erzeugt, bei dem die später dem MID-Bauteil zugewandten Ränder längs einer gemeinsamen Trennlinie (2.1) aneinandergrenzen und die betreffenden Leiterbahnen diese Trennlinie überbrücken.

3. Verfahren nach Anspruch 1 oder 2, **dadurch gekennzeichnet, dass** die Leiterbahnen der Schaltungsplatine zumindest an deren Rand zu Kontaktierungsflächen (6a) verbreitert werden.

4. Verfahren nach einem der Ansprüche 1 bis 3, **dadurch gekennzeichnet, dass** die Leiterbahnen der Schaltungsplatine und diejenigen des MID-Bauteils nach dem Reflow-Verfahren miteinander verlötet werden.

5. Verfahren nach einem der Ansprüche 1 bis 4, **dadurch gekennzeichnet, dass** der Nutzen oder die Schaltungsplatine vor der Kontaktierung mit den Leiterbahnen des MID-Bauteiles zumindest teilweise bestückt wird.

6. Verfahren nach einem der Ansprüche 1 bis 5, für MID-Bauteile, auf welche die Leiterbahnen im Heißprägeverfahren aufgebracht sind.

7. Verfahren nach einem der Ansprüche 1 bis 6, für MID-Bauteile, auf welche die Leiterbahnen durch Laserdirektstrukturierung aufgebracht sind.

## Claims

1. A method for establishing electric contact of printed conductors (5) ending at least at one edge of a printed circuit board (1) with printed conductors attached to an adjacent component, comprising the steps
a)on a panel (20) which supplies at least one printed circuit board and is copper-clad on at least one side the printed conductors of the printed circuit board are produced in a layout in which the printed conductors are extended beyond a separating line (21) defining the edge of the printed circuit board later facing the adjacent component;
b) the panel is provided along the separating line at least in the area of the printed conductors with through bores (8) ;
c) the through bores are electrically plated through;
d) the printed circuit boards are separated from the panel, and
e) every one of the printed circuit boards to be contacted is positioned relative to the respective component (10) and the adjacent printed conductors of the printed circuit board and the component are soldered together,
**characterized in that**
- the adjacent component is made of a thermoplastic material and its printed conductors are printed conductors applied with MID technology;
- the panel is provided on the rear side with electric contacting surfaces (66) in the area of the separating line coincident with the printed conductors on the front side, and metallized and through-plated bores (6d) are provided which
- connect the front-side printed conductors (5) with the rear-side contact-making surfaces (66), and
- the printed circuit board and the MID-component are positioned in such a way relative to each other that the printed conductors of the printed circuit board to be connected to each other on the one hand and the MID-components on the other hand are offset against each other with respect to height by the thickness of the printed circuit board and overlap one another.

2. A method according to claim 1 for the simultaneous production of more than one circuit board, **characterized in that** instead of the step a) the following step is used:
a') on a panel (20) supplying at least two printed circuit boards and copper-clad on at least one side the printed conductors (5) of the printed circuit boards (1.1, 1.2, 1.3, 1.4) are produced in a layout in which the edges later facing the MID-component are adjacent to one another along a common separating line (2.1) and bridge the respective printed conductors of said separating line.

3. A method according to claim 1 or 2, **characterized in that** the printed conductors of the printed circuit board are widened at least at its edge into contacting surfaces (ba).

4. A method according to one of the claims 1 to 3, **characterized in that** the printed conductors of the printed circuit board and those of the MID component are soldered together with each other according to the reflow method.

5. A method according to one of the claims 1 to 4, **characterized in that** the panel or the printed circuit board is inserted with components at least in part prior to making the contact with the printed conductors of the MID-component.

6. A method according to one of the claims 1 to 5, for MID-components to which the printed conductors are applied in the hot embossing method.

7. A method according to one of the claims 1 to 6, for MID components to which the printed conductors are applied by laser direct structuring.

## Revendications

1. Procédé de mise en contact électrique de pistes conductrices (5) se terminant sur au moins un bord d'une plaque de circuit imprimé (1) avec des pistes conductrices déposées sur un composant adjacent, du type comprenant les étapes consistant à
a) produire sur un flan (20) donnant au moins une plaque de circuit imprimé et doublé sur au moins un côté d'une fine couche de cuivre les pistes conductrices de la plaque de circuit imprimé dans une configuration dans laquelle les pistes conductrices dépassent une amorce de sectionnement (21) qui définira plus tard le bord de la plaque de circuit imprimé tourné vers le composant adjacent,
b) munir le flan de trous traversants (8) le long de l'amorce de sectionnement, du moins dans la zone des pistes conductrices,
c) métalliser les trous traversants de part en part
d) détacher les plaques de circuit imprimé du flan et
e) positionner chacune des plaques de circuit imprimé qu'il y a lieu de mettre en contact par rapport au composant respectif (10) et souder ensemble les pistes conductrices adjacentes de la plaque de circuit imprimé et du composant,
**caractérisé en ce que**
- le composant adjacent est réalisé en une matière thermoplastique dont les pistes conductrices sont déposées en technologie MID
- l'on munit le flan sur sa face arrière, du moins dans la zone de l'amorce de sectionnement, de surfaces de mise en contact électrique (6b) coïncidant avec les pistes conductrices sur sa face avant et que l'on prévoit des vias (6d) qui
- relient les pistes conductrices (5) sur la face avant avec les surfaces de mise en contact (6b) sur la face arrière et
- que l'on positionne la plaque de circuit imprimé par rapport au composant MID de telle manière que les pistes conductrices de la plaque de circuit imprimé d'une part et du composant MID d'autre part qu'il y a lieu de mettre en contact sont décalées en hauteur les unes par rapport aux autres de l'épaisseur de la plaque de circuit imprimé et se chevauchent.

2. Procédé selon la revendication 1 pour la réalisation simultanée de plus d'une plaque de circuit imprimé, **caractérisé en ce qu'**on remplace l'étape a) par l'étape suivante consistant à:
a') produire sur un flan (20) donnant au moins deux plaques de circuit imprimé et doublé sur au moins un côté d'une fine couche de cuivre les pistes conductrices (5) des plaques de circuit imprimé (1.1, 1.2, 1.3, 1.4) dans une configuration dans laquelle les bords destinés à être tournés vers le composant MID sont adjacents le long d'une amorce de sectionnement (2.1) et les pistes conductrices en question enjambent cette amorce de sectionnement.

3. Procédé selon la revendication 1 ou 2, **caractérisé en ce que** l'on élargit du moins les bords des pistes conductrices de la plaque de circuit imprimé pour en faire des surfaces de contact (6a).

4. Procédé selon l'une quelconque des revendications 1 à 3, **caractérisé en ce que** les pistes conductrices de la plaque de circuit imprimé et celles du composant MID sont soudées ensemble par refusion.

5. Procédé selon l'une quelconque des revendications 1 à 4, **caractérisé en ce qu'**on équipe du moins partiellement le flan ou la plaque de circuit imprimé avant sa mise en contact avec les pistes conductrices du composant MID.

6. Procédé selon l'une quelconque des revendications 1 à 5, pour des composants MID sur lesquels les pistes conductrices sont déposées par estampage à chaud.

7. Procédé selon l'une quelconque des revendications 1 à 6, pour des composants MID sur lesquels les pistes conductrices sont déposées par structuration directe par laser.
